# EUROPEAN PATENT SPECIFICATION

(11) **EP 2 384 521 B1**
(45) Date of publication and mention of the grant of the patent: **19.09.2018**
(21) Application number: 08879321.1
(22) Date of filing: 31.12.2008
(51) Int. Cl.: H01P 1/15, H03K 17/74, H01L 29/868

(54) **MONOLITHIC SEMICONDUCTOR MICROWAVE SWITCH ARRAY**
MIKROWELLENSCHALTANORDNUNG MIT MONOLITHISCHEM HALBLEITER
MATRICE DE COMMUTATION HYPERFRÉQUENCE À SEMI-CONDUCTEUR MONOLITHIQUE

(43) Date of publication of application: 09.11.2011
(73) Proprietor: Sierra Nevada Corporation, Sparks, NV 89434 (US)
(72) Inventor: MANASSON, Vladimir, Irvine, California 92614 (US); LITVINOV, Vladimir, I., Aliso Viejo, California 92656 (US); SADOVNIK, Lev, Irvine, California 92612 (US); AVAKIAN, Aramais, Pasadena, California 91104 (US)
(74) Representative: Budde Schou A/S
(86) International application number: PCT/US2008/088673
(87) International publication number: WO 2010/077248

(56) References cited:
- WO-A1-2005/109636
- WO-A2-01/71819
- US-A- 3 959 794
- US-A- 4 810 980
- US-A- 5 047 829
- US-A- 5 272 457
- US-B2- 6 949 985
- YASHCHYSHYN Y ET AL: "A Reconfigurable Leaky-Wave Microstrip Antenna", 2005 EUROPEAN MICROWAVE CONFERENCE CNIT LA DEFENSE, PARIS, FRANCE OCT. 4-6, 2005, PISCATAWAY, NJ, USA,IEEE, vol. 1, 4 October 2005 (2005-10-04), pages 237-240, XP010903599, DOI: 10.1109/EUMC.2005.1608837 ISBN: 978-2-9600551-2-2
- FATHY A E ET AL: "SILICON-BASED RECONFIGURABLE ANTENNAS-CONCEPTS, ANALYSIS, IMPLEMENTATION, AND FEASIBILITY", IEEE TRANSACTIONS ON MICROWAVE THEORY AND TECHNIQUES, IEEE SERVICE CENTER, PISCATAWAY, NJ, US, vol. 51, no. 6, 1 June 2003 (2003-06-01), pages 1650-1661, XP001163339, ISSN: 0018-9480, DOI: 10.1109/TMTT.2003.812559
- TANABE M ET AL: "A lateral P-SI-N diode SPDT switch for Ka-band applications", GAAS IC SYMPOSIUM, 1999. 21ST ANNUAL MONTEREY, CA, USA 17-20 OCT. 1999, PISCATAWAY, NJ, USA,IEEE, US, 17 October 1999 (1999-10-17), pages 263-266, XP032398157, DOI: 10.1109/GAAS.1999.803772 ISBN: 978-0-7803-5585-9
- YASHCHYSHYN Y: "Antenna systems with reconfigurable aperture: Concept, analysis and investigation", MODERN PROBLEMS OF RADIO ENGINEERING, TELECOMMUNICATIONS AND COMPUTER SCIENCE, 2008 PROCEEDINGS OF INTERNATIONAL CONFERENCE ON, IEEE, PISCATAWAY, NJ, USA, 19 February 2008 (2008-02-19), pages 155-158, XP031644113, ISBN: 978-966-553-678-9

## Description

### BACKGROUND

The present disclosure relates to semiconductor switches for switching, controlling and/or directing electromagnetic radiation, particularly microwave radiation in the portion of the spectrum known as "millimeter waves." Such millimeter wave radiation typically is employed in many radar applications, particularly collision avoidance radar used in various types of vehicles and craft.

Semiconductor microwave switches are known in the art. and have been employed in such applications as steerable or directional antennas, especially dielectric waveguide antennas used to send and receive steerable millimeter wave beams in various types of radar devices, such as collision avoidance radars. In such antennas, semiconductor switches may be employed to provide an antenna element with an evanescent coupling edge having a selectively variable coupling geometry. The coupling edge is placed substantially parallel and closely adjacent to a transmission line, such as a dielectric waveguide. As a result of evanescent coupling between the transmission line and the antenna element when an electromagnetic signal is transmitted through the transmission line, electromagnetic radiation is transmitted or received by the antenna. The shape and direction of the transmitted or received beam are determined by the selected coupling geometry of the evanescent coupling edge, as determined, in turn, by the pattern of electrical connections that is selected for the edge features of the coupling edge. Semiconductor switches may be employed in the antenna element as one mechanism for varying this pattern of electrical connections. See, for example, US Patent 7,151,499 (commonly assigned to the assignee of the present application).

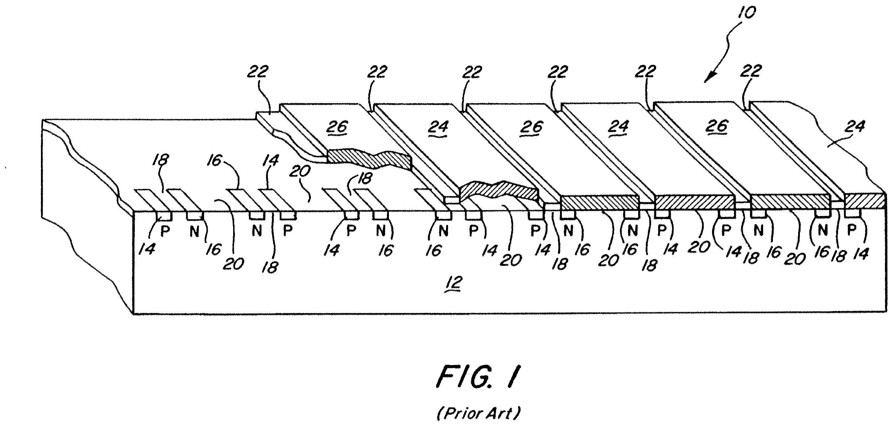

A typical prior art semiconductor microwave switch array 10 that may be used in an antenna of the aforementioned type is shown in Fig. 1. The prior art switch array 10 is formed on a wafer or substrate 12 of semiconductor material (e.g., Si, Ge, or GaAs) by forming a plurality of PIN junctions, each comprising a P-doped region that serves as a P-type electrode 14, an N-doped region that serves as an N-type electrode 16, and an insulative substrate gap 18 between the two electrodes 14, 16. Successive PIN junctions are separated by an insulative substrate region 20, and the successive PIN junctions are of alternating polarity (i.e., P-I-N, alternating with N-I-P), as shown in Fig. 1. The surface of the substrate 12 is covered by a thin passivation layer, which may be a suitable insulative material, such as SiO₂ or Si₃N₄. for example. The passivation layer is subjected to a first photolithography process to form a linear passivation region 22 overlying each of the insulative substrate gaps 18. A metal layer (e.g., Ag, Al, Au. Cu, Pt) is then formed or deposited over the surface of the substrate 12 and over the passivation regions 22 by any suitable conventional process (e.g. electroplating or electrodeposition). The metal layer is then subjected to a second photolithography process to form an array of first contacts 24 and an array of second contacts 26, wherein each of the first contacts 24 is separated from its adjacent second contact 26 by an exposed passivation region 22. Each of the first contacts 24 thus connects the P-type electrodes 14 in each adjacent pair of PIN junctions, while each of the second contacts 26 connects the N-type electrodes 16 in each adjacent pair of PIN junctions. An example of a prior art device is disclosed in US 4,810,980 describing a switched limiter with variable attenuation, designed with monolithic GaAs p-i-n diodes and n-i-p diode. Greater than 30 dB of small-signal variable attenuation is achieved at X band frequencies, with a minimum insertion loss of 0.5 dB. The variable attenuation switched limiter provides 15 dB of isolation to a +30 dBm input signal to the input terminal. Under bias conditions that result in variable attenuation, the variable attenuation switched limiter input impedance remains matched. When used as a passive limiter, 7 dB of limiting has been achieved for a +30 dBm input signal at 10 GHz

Each of the PIN junctions provides a switch having an "open" state when no potential is applied across the junction, and a "'closed" state when a potential above a predefined threshold potential is applied across the junction. When a switch is open, the exposed passivation region 22 provides a "'slotline" through which electromagnetic radiation of suitable wavelength may be directed. When a suitable potential is applied across the PIN junction, the switch is closed, and an electron-hole plasma (not shown) is created and injected into the passivation region 22 between the electrodes 14 16, thereby shorting the electrodes. This plasma reflects the electromagnetic radiation, effectively blocking the path of the radiation through the slotline provided by the passivation region 22.

One disadvantage of the prior art semiconductor switch array 10, as described above, is that the plasma created by the application of the potential across the electrodes of each PIN junction switch is not effectively confined to the area in the vicinity of that switch. Thus, in the switch array 10, the plasma created by each PIN junction switch tends to diffuse across the surface of the substrate 12, so that it may "contaminate" other switches and slotlines in the array, thereby degrading the performance of those switches and slotlines, and compromising the functioning of the array as a whole. Moreover, within each switch, the plasma tends to diffuse along the length of the slotline, away from the electrodes, thereby degrading the performance of the slotline controlled by that switch.

Thus, it would be a significant improvement in the state of the art to provide a semiconductor microwave switch in which the effects of plasma diffusion are minimized, without compromising the overall performance of the switch or of any array of which the switch forms a part. It would be a further advantage to provide such a switch without substantially increasing the cost of manufacture of the switch or the switch array.

### SUMMARY OF THE DISCLOSURE

Broadly, this disclosure describes a semiconductor microwave switch as defined in claim 1.

The present disclosure also describes a monolithic array of semiconductor microwave switches, each of which is a semiconductor microwave switch of the type described herein.

In another aspect of the invention, the present disclosure describes a method of manufacturing a monolithic array of semiconductor microwave switches as defined in claim 4.

As will be better appreciated from the detailed description below, an array of semiconductor microwave switches constructed in accordance with this disclosure minimizes, or at least substantially reduces, the deleterious effects of plasma diffusion, as described above.

As used herein, the term "microwaves" and "microwave radiation" shall include electromagnetic radiation having any wavelength that is suitable for use in radar, communications, and similar applications, including so-called "millimeter waves." Likewise, the term "microwave switch," as used herein, shall include any switch that may be used to control the passage of electromagnetic radiation of any wavelength that is suitable for use in radar, communications, and similar applications

### BRIEF DESCRIPTION OF THE DRAWINGS

Figure 1 is a semi-schematic perspective view, partially in cross-section, of an array of typical prior art semiconductor microwave switches;
Figures 2-5 are semi-schematic cross-sectional views of a semiconductor wafer or substrate showing the steps of fabricating an array of semiconductor microwave switches in accordance with the present disclosure;
Figure 6 is a semi-schematic exploded perspective view of an array of semiconductor microwave switches in accordance with the present disclosure; and
Figure 7 is a semi-schematic perspective view, partially in cross-section, of an array of semiconductor microwave switches in accordance with the present disclosure.

### DETAILED DESCRIPTION OF THE PREFERRED EMBODIMENT

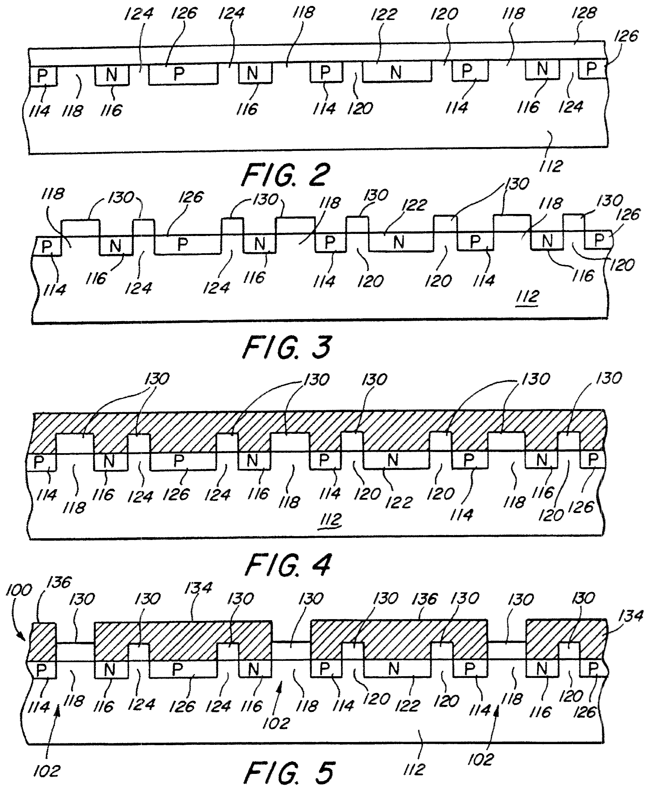

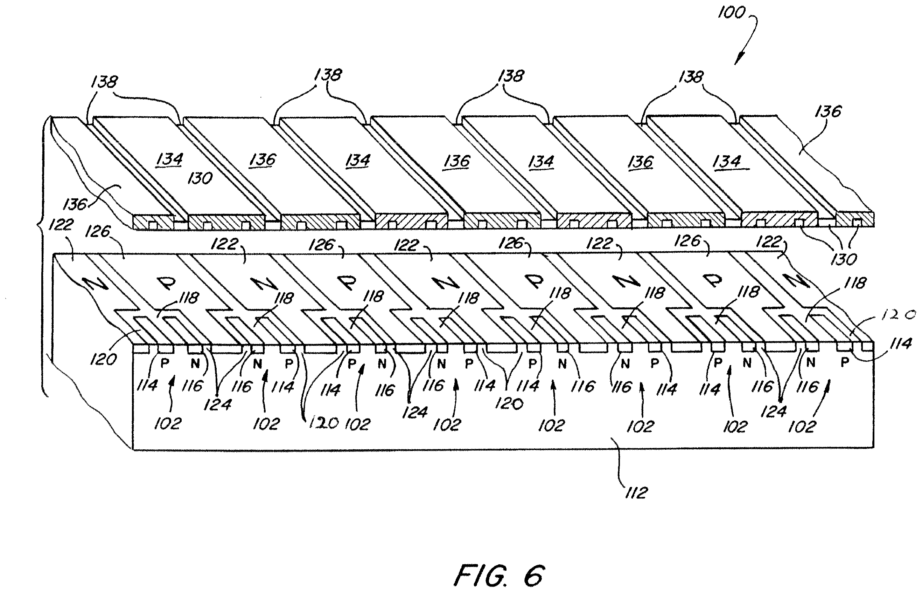

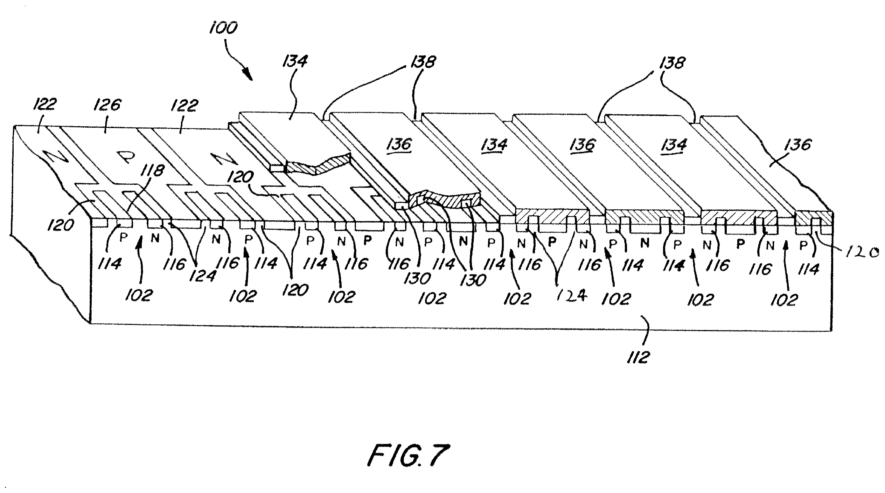

Figures 5, 6, and 7 show a monolithic array 100 of semiconductor microwave switches 102, in accordance with the present disclosure, while Figures 2, 3, and 4 show several steps in the fabrication of the array 100. The array 100 of the switches 102 is formed on a wafer or substrate 112 of undoped semiconductor material, such as Si, Ge, or GaAs. Each of the switches 102 is a PIN junction switch, comprising a first PIN junction provided by a first P-doped region that serves as a primary P-type electrode 114 and a first N-doped region that serves as a primary N-type electrode 116, the primary electrodes 114, 116 being separated by an insulative region 118 of undoped substrate material. A second PIN junction is provided by forming a second N-doped region separated from the primary P-type electrode 114 by a first isolation gap 120, the second N-doped region serving as a secondary N-type electrode 122. A third PIN junction is provided by forming a second P-doped region separated from the primary N-type electrode 116 by a second insulative isolation gap 124, the second P-doped region serving as a secondary P-type electrode 126. The secondary N-type electrode 122 is separated from the secondary P-type electrode 126 by the slot 118. Thus, in the preferred embodiment shown in the drawings, the primary P-type electrode 114 is isolated from the secondary N-type electrode 122 by the first isolation gap 120, and from the primary N-type electrode 116 by the insulative region 118. Similarly, the primary N-type electrode 116 is isolated from the secondary P-type electrode by the second isolation gap 124, and from the primary P-type electrode by the insulative region 118. Although the first and second isolation gaps 120, 124 are shown as right-angle gaps, their actual configuration in practice will be dictated largely by the respective configurations of the primary and secondary electrodes.

In fabricating the array 100, a major surface of an undoped, semiconductive substrate 112 is doped, by conventional methods (diffusion, epitaxy, ion implantation, etc.), to form the P-doped regions and N-doped regions that provide the primary P-type electrodes 114, the primary N-type electrodes 116, the secondary N-type electrodes 122, and the secondary P-type electrodes 126. Each primary P-type electrode 114 is separated from a corresponding primary N-type electrode 116 by an undoped substrate region 118. Each secondary N-type electrode 122 is separated from a corresponding primary P-type electrode 114 by a first isolation gap 120 of undoped substrate material, while each secondary P-type electrode 126 is separated from a corresponding primary N-type electrode by a second isolation gap 124 of undoped substrate material.

A thin passivation layer 128 is then applied to the surface of the substrate 112 that includes the doped regions, as shown in Fig. 2. The passivation layer 128 may be a suitable insulative material, such as SiO₂ or Si₃N₄, for example. Selected portions of the passivation layer 128 are removed, as by a first photolithography process (masking and etching), for example, to leave a pattern of insulative passivation regions or islands 130 on the substrate surface, as shown in Fig. 3. The passivation regions or islands 130 overly the undoped substrate regions 118 and the first and second isolation gaps 120, 124, respectively.

Next, a layer of conductive metal 132 is formed or deposited, by any suitable conventional method (such as vacuum deposition, sputtering, electron-beam deposition, etc. following by electroplating or electrodeposition, if necessary), over the entire substrate surface so as to cover the electrodes 114, 116, 122, 126 and the passivation regions or islands 130, as shown in Fig. 4. Any suitable conductive metal (e.g., Ag, Al, Au, Cu, Pt. nickel-over-copper) or metal silicide (e.g., TiSi₂) may be used for the metal layer 132. Finally, as shown in Fig. 5, selected portions of the metal layer 132 are removed, as by a second photolithography process, for example, to form an array of first metal contacts 134 and an array of second metal contacts 136, with each pair of first and second metal contacts 134, 136 being separated by an exposed passivation region 130 overlying each of the insulative regions 118 of the substrate 112. Each of the first contacts 134 is disposed on one of the secondary P-type electrodes 126 and the two primary N-type electrodes 122 on either side of it so as to bridge these three electrodes across the first and second isolation gaps 120, 124. Similarly, and simultaneously, each of the second metal contacts 136 is disposed on one of the secondary N-type electrodes 122 and the two primary P-type electrodes 114 on either side of it so as to bridge these three electrodes across the first and second isolation gaps 122, 124. The array of first and second metal contacts 134, 136 thus covers all of the surface of the substrate 112, except for the exposed passivation regions 130 overlying the insulative regions 118 of the substrate 112. In the resultant structure, as shown in Figures 5-7, a microwave slotline 138 is provided by each of the exposed passivation regions 130 separating a contact pair 134, 136, whereby each slotline 138 is located between a primary P-type electrode 114 and a corresponding primary N-type electrode 116.

As in the prior art switch of Fig. 1, the selective application of a potential across the first PIN junction (i.e., between the primary electrodes 114. 116 across the slotline 138) creates an electron-hole plasma that is injected into the slotline 138, blocking the propagation of electromagnetic radiation along the length of the slotline 138. When the potential is removed from the first PIN junction, plasma injection ceases, and propagation of the radiation through the slotline 138 is permitted. In the embodiment of Figs. 5-7, however, the electrical contact provided by the metallized contacts 134, 136 between each of the secondary electrodes 122, 126 and its respective primary electrode 114, 116 has the effect of localizing the injected plasma to a portion of the slotline 138 that is in or in close proximity to the region directly between the primary electrodes 114, 116. This localization of the plasma minimizes, or at least substantially reduces, the diffusion of the plasma away from the first PIN junction that provides the microwave switching function. In this way, the plasma used to block the microwave propagation through the slotline 138 is substantially confined to the area where the desired switching is to take place, and the diffusion of the plasma away from this area is substantially reduced. As a result, the performance of each individual switch is not significantly degraded by the diffusion of its own injected plasma along the length of the slotline 138. nor are the switches in an array of such switches deleteriously affected by plasma diffusing from neighboring slotlines in the array.

In operation, when a potential is applied across the primary electrodes 114, 116 so that they are forward biased, the P-type primary electrode 114 injects holes into the slotline 138, while the N-type primary electrode 116 injects electrons. The injected holes and electrons form the injected plasma. The secondary electrodes 122, 126, being unbiased (because the contacts 134, 136 put them at the same potential as their respective primary electrodes), effectively extract the plasma that is in their vicinity, with the secondary N-type electrode 122 extracting electrons, and the secondary P-type electrode 126 extracting holes. The plasma extraction is based on the "drift" phenomenon, in which the charged plasma particles drift in the "built-in" or inherent electric fields created at the second and third PIN junctions. This drift phenomenon is several orders of magnitude more efficient than the diffusion of the plasma away from the first PIN junction, thereby providing a highly effective and efficient collection of the electrons and holes by the secondary N-type electrode 122 and the secondary P-type electrode 126, respectively. Accordingly, the secondary electrodes 122, 126, by effectively collecting the plasma through the drift phenomenon, keep the plasma from diffusing away from the first PIN junction formed by the primary electrodes 114, 116 and the slotline 138.

As will be appreciated from the above description, by virtue of the secondary N-type electrodes 122 and the secondary P-type electrodes 126, each of the switches 102 in the array 100 is allowed to function with optimum efficiency, and with a minimum of performance-degrading interference from plasma diffusion, either along the slotline of that switch, or from other switches in the array. As a result, very precise operation of the array 100 is permitted, making the array 100 particularly advantageous for use in a beam-shaping or "steerable" microwave antenna, of the type described above.

While a preferred embodiment has been described herein, it will be appreciated that various modifications and variations may suggest themselves as equivalents to the disclosed embodiment. Such variations and modifications as may be considered equivalents are encompassed within the scope of this disclosure as defined in the claims that are appended hereto.

## Claims

1. A semiconductor microwave switch (102), comprising:
- a primary P-type electrode (114);
- a primary N-type electrode (116);
- an insulative slot (118, 138) separating the primary P-type and N-type electrodes;
- a secondary N-type electrode (122) separated from the primary P-type electrode by a first insulative gap (120);
- a first metal contact (134) connecting the secondary N-type electrode and the primary P-type electrode; **characterized by**
- a secondary P-type electrode (126) separated from the primary N-type electrode by a second insulative gap (124) ; and
- a second metal contact (136) connecting the secondary P-type electrode and the primary N-type electrode;
wherein the secondary N-type electrode is separated from the secondary P-type electrode by the insulative slot (138).

2. A monolithic array (100) of semiconductor microwave switches (102), each of which is a semiconductor microwave switch as defined in claim 1.

3. The monolithic semiconductor switch array (100) of claim 2, further comprising:
- a plurality of first metal contacts (134), each of which connects one of the secondary N-type electrodes (122) with one of the primary P-type electrodes (114) on either side of it; and
- a plurality of second metal contacts (136), each of which connects one of the secondary P-type electrodes (126) with one of the primary N-type electrodes (116) on either side of it.

4. A method of fabricating a monolithic array (100) of semiconductor microwave switches (102), the method comprising:
(a) providing a substrate (112) of undoped semiconductive material having a major surface;
(b) doping the major surface of the substrate to form a plurality of primary P-type electrodes (114), a plurality of primary N-type electrodes (116), a plurality of secondary N-type electrodes (122), and a plurality of secondary P-type electrodes (126), each of the primary P-type electrodes being separated from a corresponding one of the primary N-type electrodes by an undoped substrate region, and each of the secondary N-type electrodes (122) is separated from a primary P-type electrode (114) on either side of it by a first isolation gap (120) of undoped substrate material, and each of the secondary P-type electrodes (126) is separated from a primary N-type electrode on either side of it by a second isolation gap (124) of undoped substrate material;
(c) covering the major surface with an insulative passivation layer (128);
(d) removing selected portions of the passivation layer (128) to leave a pattern of insulative passivation regions or islands (130) on the substrate major surface, in such a way that the passivation regions or islands (130) are overlying the undoped substrate regions;
(e) forming a layer of conductive metal (132) over the substrate major surface so as to cover the passivation regions or islands (130); and
(f) removing selected portions of the metal layer (132) to form an array of first metal contacts (134) and an array of second metal contacts (136), each pair of first and second metal contacts (134, 136) being separated by an exposed passivation region or island (130, 138) overlying each of the undoped substrate regions, and so that each of the first contacts (134) connects one of the secondary N-type electrodes (122) with the primary P-type electrodes (114) on either side of it across one of the first isolation gaps (120), and so that each of the second contacts connects one of the secondary P-type electrodes (126) with the primary N- type electrodes (116) on either side of across one of the second isolation gaps (124);
whereby a microwave slotline (138) is provided by each of the exposed passivation regions (130) separating one of the first contacts (134) from a corresponding one of the second contacts (136),
whereby each slotline (138) is located between one of the primary P-type electrodes (114) and a corresponding one of the primary N-type electrodes (116), and
wherein the secondary N-type electrode is separated from the secondary P-type electrode by the slotline (138).

5. The method of claim 4, wherein at least one of the steps of removing selected portions of the passivation layer (128) and removing selected portions of the metal layer is (132) performed by photolithography.

6. The method of claim 4, wherein the step of removing selected portions of the passivation layer (128) is performed so that the passivation regions or islands (130) overly the undoped substrate regions (118) and the first and second isolation gaps (120, 124).

## Patentansprüche

1. Mikrowellenschalter mit Halbleiter (102), umfassend:
- eine primäre p-Typ Elektrode (114);
- eine primäre n-Typ Elektrode (116);
- einen Isolierschlitz (118, 138), der die primären p-Typ und n-Typ Elektroden trennt;
- eine sekundäre n-Typ Elektrode (122), die von der primären p-Typ Elektrode durch einen ersten Isolierspalt (120) getrennt ist;
- einen ersten Metallkontakt (134), der die sekundäre n-Typ Elektrode mit der primären p-Typ Elektrode verbindet;
- **gekennzeichnet durch**
- eine sekundäre p-Typ Elektrode (126), die von der primären n-Typ Elektrode durch einen zweiten Isolierspalt (124) getrennt ist ; und
- einen zweiten Metallkontakt (136), der die sekundäre p-Typ Elektrode mit der primären n-Typ Elektrode verbindet;
wobei die sekundäre n-Typ Elektrode von der sekundären p-Typ Elektrode durch den Isolierschlitz (138) getrennt ist.

2. Monolithische Anordnung (100) von Mikrowellenschaltern mit Halbleiter (102), von denen jeder ein Mikrowellenschalter mit Halbleiter wie in Anspruch 1 definiert ist.

3. Schaltanordnung mit monolithischem Halbleiter (100) nach Anspruch 2, ferner umfassend:
- eine Vielzahl von ersten Metallkontakten (134), von denen jeder eine der sekundären n-Typ Elektroden (122) mit einer der primären p-Typ Elektroden (114) auf jeder Seite davon verbindet; und
- eine Vielzahl von zweiten Metallkontakten (136), von denen jeder eine der sekundären p-Typ Elektroden (126) mit einer der primären n-Typ Elektroden (116) auf jeder Seite davon verbindet.

4. Verfahren zur Herstellung einer monolithischen Anordnung (100) von Mikrowellenschaltern mit Halbleiter (102), wobei das Verfahren umfasst:
(a) Bereitstellen eines Substrats (112) aus undotiertem Halbleitermaterial mit einer Hauptoberfläche;
(b) Dotieren der Hauptoberfläche des Substrats, um eine Vielzahl von primären p-Typ Elektroden (114), eine Vielzahl von primären n-Typ Elektroden (116), eine Vielzahl von sekundären n-Typ Elektroden (122), und eine Vielzahl von sekundären p-Typ Elektroden (126) zu bilden, wobei jede der primären p-Typ Elektroden von einer entsprechenden Elektrode der primären n-Typ Elektroden durch einen undotierten Substratbereich getrennt ist, und jede der sekundären n-Typ Elektroden (122) von einer primären p-Typ Elektrode (114) auf beiden Seiten davon durch einen ersten Isolierspalt (120) aus undotiertem Substratmaterial getrennt ist, und jede der sekundären p-Typ Elektroden (126) von einer primären n-Typ Elektrode auf beiden Seiten davon durch einen zweiten Isolierspalt (124) aus undotiertem Substratmaterial getrennt ist;
(c) Bedecken der Hauptoberfläche mit einer isolierenden Passivierungsschicht (128);
(d) Entfernen von ausgewählten Teilen der Passivierungsschicht (128), um ein Muster aus isolierenden Passivierungsbereichen oder -inseln (130) an der Substrathauptoberfläche zu hinterlassen, auf eine solche Weise, dass die Passivierungsbereiche oder -inseln (130) die undotierten Substratbereiche überdecken;
(e) Bilden einer Schicht aus leitfähigem Metall (132) über der Hauptoberfläche, um so die Passivierungsbereiche oder -inseln (130) zu bedecken; und
(f) Entfernen von ausgewählten Teilen der Metallschicht (132), um eine Anordnung von ersten Metallkontakten (134) und eine Anordnung von zweiten Metallkontakten (136) zu bilden, wobei jedes Paar erste und zweite Metallkontakte (134, 136) durch eine(n) freiliegende(n) Passivierungsbereich oder -insel (130, 138) getrennt ist, der/die jeden der undotierten Substratbereiche überdeckt, und so dass jeder der ersten Kontakte (134) eine der sekundären n-Typ Elektroden (122) mit den primären p-Typ Elektroden (114) auf beiden Seiten davon über einen der ersten Isolierspalte (120) verbindet, und so dass jeder der zweiten Kontakte eine der sekundären p-Typ Elektroden (126) mit den primären n-Typ Elektroden (116) auf beiden Seiten davon über einen der zweiten Isolierspalte (124) verbindet;
wobei eine Mikrowellenschlitzlinie (138) durch jeden der freiliegenden Passivierungsbereiche (130) bereitgestellt ist, der einen der ersten Kontakte (134) von einem entsprechenden Kontakt der zweiten Kontakte (136) trennt,
wobei jede Schlitzlinie (138) zwischen einer der primären p-Typ Elektroden (114) und einer entsprechenden Elektrode der primären n-Typ Elektroden (116) angeordnet ist, und
wobei die sekundäre n-Typ Elektrode von der sekundären p-Typ Elektrode durch die Schlitzlinie (138) getrennt ist.

5. Verfahren nach Anspruch 4, wobei mindestens einer der Schritte des Entfernens von ausgewählten Teilen der Passivierungsschicht (128) und des Entfernens von ausgewählten Teilen der Metallschicht (132) durch Photolithographie durchgeführt wird.

6. Verfahren nach Anspruch 4, wobei der Schritt des Entfernens von ausgewählten Teilen der Passivierungsschicht (128) derart durchgeführt wird, dass die Passivierungsbereiche oder -inseln (130) die undotierten Substratbereiche (118) und die ersten und zweiten Isolierspalte (120, 124) überdecken.

## Revendications

1. Commutateur hyperfréquence à semiconducteur (102) comprenant:
- une électrode primaire du type P (114);
- une électrode primaire du type N (116);
- une encoche isolante (118, 138) séparant les électrodes du type P et du type N;
- une électrode secondaire du type N (122) séparée de l'électrode primaire du type P par un premier espace isolant (120);
- un premier contact métallique (134) qui connecte l'électrode secondaire du type N et l'électrode primaire du type P;
**caractérisé par**
- une électrode secondaire du type P (126) séparée de l'électrode primaire du type N par un deuxième espace isolant (124); et
- un deuxième contact métallique (136) connectant l'électrode secondaire du type P et l'électrode primaire du type N;
où l'électrode secondaire du type N est séparée de l'électrode secondaire du type P par l'encoche isolante (138).

2. Matrice monolithique (100) de commutateurs hyperfréquence à semiconducteur (102), dont chacun est un commutateur hyperfréquence à semiconducteur comme défini dans la revendication 1.

3. Matrice de commutation à semiconducteur monolithique (100) selon la revendication 2, comprenant en outre:
- une pluralité de premiers contacts métalliques (134), dont chacun connecte l'une des électrodes secondaires du type N (122) avec l'une des électrodes primaires du type P (114) sur n'importe lequel des côtés de celle-ci; et
- une pluralité de deuxième contacts métalliques (136), dont chacun connecte l'une des électrodes secondaires du type P (126) avec l'une des électrodes primaires du type N (116) sur n'importe lequel des côtés de celle-ci.

4. Procédé de fabrication d'une matrice monolithique (100) de commutateurs hyperfréquences à semiconducteur (102), le procédé comprenant:
(a) la fourniture d'un substrat (112) d'une matière semiconductrice non dopée ayant une surface principale;
(b) le dopage de la surface principale du substrat pour former une pluralité d'électrodes primaires du type P (114), une pluralité d'électrodes primaires du type N (116), une pluralité d'électrodes secondaires du type N (122), et une pluralité d'électrodes secondaires du type P (126), chacune des électrodes primaires du type P étant séparée d'une des électrodes primaires du type N correspondantes par une région de substrat non dopée, et
chacune des électrodes secondaires du type N (122) est séparée d'une électrode primaire du type P (114) sur n'importe quel côté de celle-ci par un premier espace isolant (120) de matière de substrat non dopée, et chacune des électrodes secondaires du type P (126) est séparée d'une électrode primaire du type N sur n'importe quel côté de celle-ci par un deuxième espace isolant (124) de matière de substrat non dopée;
(c) la couverture de la surface majeure/principale avec une couche de passivation isolante (128);
(d) l'enlèvement de parties sélectionnées de la couche de passivation (128) afin de laisser un profil de régions de passivation isolantes ou des îlots (130) sur la surface principale du substrat, d'une telle manière que les régions de passivation isolantes ou les îlots (130) recouvrent les régions de substrat non dopées;
(e) la création d'une couche de métal conducteur (132) par dessus la surface principale de substrat de manière à couvrir les régions de passivation ou les îlots (130); et
(f) enlever des parties sélctionnées de la couche métallique (132) pour former une matrice de premiers contacts métalliques (134) et une matrice de deuxième contacts métalliques (136), chaque paire de premier et deuxième contacts métalliques (134, 136) étant séparée par une région de passivation exposée ou îlot (130, 138) recouvrant chacune des régions de substrat non dopées, et de manière à ce que chacun des premiers contacts (134) connecte l'une des électrodes secondaires du type N (122) avec les électrodes primaires du type P (114) sur n'importe quel côté de celle-ci par dessus un des premiers espaces isolants (120), et de manière à ce que chacun des deuxième contacts connecte l'une des électrodes secondaires du type P (126) avec les électrodes primaires du type N (116) sur n'importe quel côté par dessus l'un des deuxième espaces isolant (124);
par quoi une ligne d'encoche hyperfréquence (138) est fournie par chacune des régions de passivation exposées (130) séparant l'un des premiers contacts (134) de l'un correspondant des deuxièmes contacts (136),
par quoi chaque ligne d'encoche (138) est localisée entre l'une des électrodes primaires du type P (114) et l'une correspondante des électrodes primaires du type N (116), et
où l'électrode secondaire du type N est séparée de l'électrode secondaire du type P par la ligne d'encoche (138).

5. Procède selon la revendication 4, où au moins l'une des étapes consistant à enlever des parties sélectionnées de la couche de passivation (128) et d'enlever des parties sélectionnées de la couche métallique (132) sont effectuées par photolitographie.

6. Procède selon la revendication 4, où l'étape consistant à enlever des parties sélectionnées de la couche de passivation (128) est effectuée de manière à ce que les régions de passivation ou les îlots (130) recouvrent les régions de substrat non dopées (118) et les premier et deuxième espaces isolants (120, 124).
